# EUROPEAN PATENT APPLICATION

(11) **EP 1 533 894 A1**
(43) Date of publication of application: **25.05.2005**
(21) Application number: 03736297.7
(22) Date of filing: 27.06.2003
(51) Int. Cl.: H03F 3/19

(54) **SEMICONDUCTOR INTEGRATED CIRCUIT AND SEMICONDUCTOR INTEGRATED CIRCUIT MANUFACTURING METHOD**

(30) Priority: 08.07.2002 JP 2002198928
(71) Applicant: Kabushiki Kaisha Toyota Jidoshokki, Kariya-shi, Aichi-ken 448-8671 (JP); Niigata Seimitsu Co., Ltd., Niigata 943-0834 (JP)
(72) Inventor: MIYAGI, Hiroshi, c/o NIIGATA SEIMITSU CO., LTD, Joetsu-shi, Niigata 943-0834 (JP)
(74) Representative: Leson, Thomas Johannes Alois, Dipl.-Ing.
(86) International application number: PCT/JP2003/008227
(87) International publication number: WO 2004/006429

(57) **Abstract**

An RF amplifier circuit 21 for amplifying AM broadcast signals is constituted by use of cascaded P channel MOSFETs 4 and 5. This cascade connection realizes a reduction of the feedback capacitance between the source and gate of the P channel MOSFET 4, thereby providing a stable operation. Further, using the P channel MOSFETs to constitute the amplifier circuit realizes a reduction of flicker noise and allows the amplifier circuit to be manufactured by the same CMOS process as the CMOS digital circuit.

## Description

### Technical Field

The present invention relates to a semiconductor integrated circuit having an amplifier circuit for amplifying AM broadcast signals and the method of manufacturing the same.

### Background Art

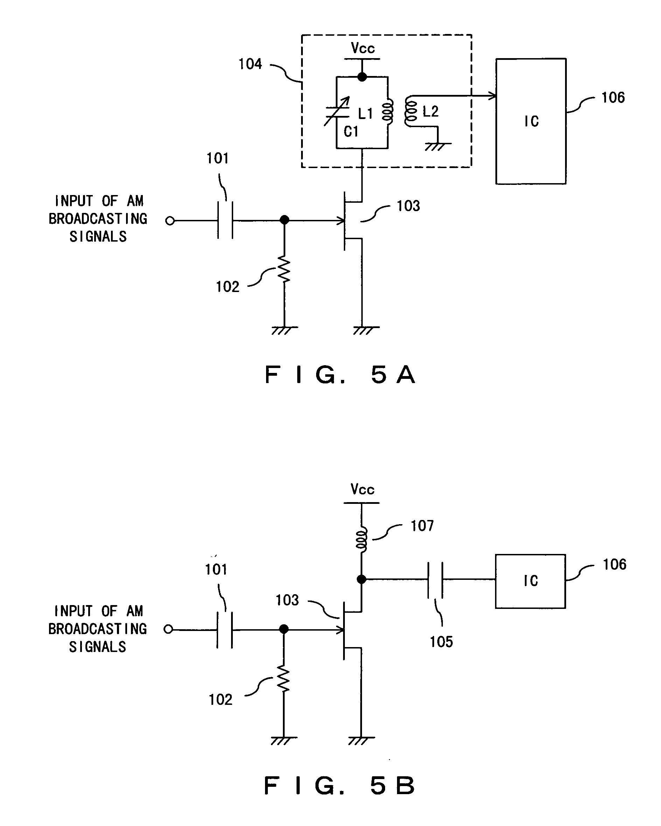

The configuration of a conventional AM-broadcast receiving circuit is shown in Fig. 5. Fig. 5 (a) shows the configuration of a tuning circuit method, and Fig. 5 (b) shows the configuration of an aperiodic circuit method.

The AM-broadcast receiving circuit of the tuning circuit method shown in Fig. 5 (a) comprises a capacitor 101, a resistor 102, an FET (field effect transistor) for signal amplication 103, a tuning circuit 104, and an IC 106. An RF amplifier comprises the capacitor 101, resistor 102, FET for signal amplification 103, and tuning circuit 104 among all these components.

The capacitor 101 is used to cut the DC component of AM broadcast signals inputted from an antenna which is not shown in Fig. 5, and comprises a tuning capacitor C1 and tuning coils L1 and L2. One end of the tuning circuit 104 is connected to a power source Vcc. The IC 106 inputs an RF amplifier signal outputted from the tuning circuit 104, and implements the signal processing at a later step necessary to receive AM broadcast signals including mixing and frequency conversion.

The AM-broadcast receiving circuit of an aperiodic circuit method comprises the capacitor 101, resistor 102, FET for signal amplification 103, coupling capacitor 105, IC 106 and coil 107, as shown in Fig. 5 (b). The RF amplifier comprises the capacitor 101, resistor 102, FET for signal amplification 103, coupling capacitor 105 and coil 107 among all these components.

In recent years, integration of an RF circuit has been promoted in a radio terminal which handles a high-frequency signal in 2.4 GHz and 5 GHz bands, and an LSI has been developed which integrates an RF circuit which used to be externally mounted as an individual analog part into one chip by means of a MOS technology. Furthermore, an LSI which integrates an RF circuit by means of a MOS technology has been developed in an FM broadcast receiver which uses a frequency band from 76 MHz to 90 MHz. An RF amplifier is also included in the RF circuit which is integrated into one chip.

In an AM broadcast receiver which uses a low-frequency signal in a MF band from 530 kHz to 1, 710 KHz and in a LF band from 153 KHz to 279 KHz, since the frequency bands exist in the region in which a flicker noise component is large, it was considered difficult to constitute an RF amplifier using MOSFETs.

Consequently, the conventional RF amplifier of an AM broadcast receiver was designed using a junction type FET (JFET) 103 as the RF amplifier or combining the JFET and a bipolar transistor, as shown in Fig. 5.

However, since JFET differs from MOS in the manufacturing process, and cannot be integrated into one chip, the JFET was mounted outside of the chip of an IC 106 as an individual part. As a result, there was a problem in that an RF circuit of a high-frequency radio terminal cannot be miniaturized.

Furthermore, since an AM amplifier circuit amplifies a feeble signal, it is desired to give a stable bias to an FET against the fluctuations, etc. of a power-supply voltage.

### Disclosure of Invention

The purpose of the present invention is to integrate an amplifier circuit for amplifying AM broadcast signals and a CMO digital circuit into one chip. Another purpose of the present invention is to stabilize the bias of an AM amplifier circuit.

The semiconductor integrated circuit of the present invention has an amplifier circuit of AM broadcast signals which comprises a first P channel MOSFET for amplifying AM broadcast signals and a second P channel MOSFET cascade-connected to the first P channel MOSFET, and a CMOS digital circuit.

According to the present invention, using a P channel MOSFET realizes a reduction of the flicker noise of the amplifier circuit for amplifying AM broadcast signals, and allows the amplifier circuit of the AM broadcast signals and the CMOS digital circuit to be integrated into one chip by, for example, a CMOS process.

Another semiconductor integrated circuit of the present invention has an amplifier circuit of AM broadcast signals comprising a first P channel MOSFET for amplifying AM broadcast signals and a bias circuit for giving a specific bias to the first P channel MOSFET, and a CMOS digital circuit, and forms the first P channel MOSFET, the bias circuit, and the CMOS digital circuit on the same circuit board by a CMOS process.

According to this invention, the flicker noise of the amplifier circuit for amplifying AM broadcast signals can be reduced, and the amplifier circuit of the AM broadcast signals and the CMOS digital circuit can be integrated into one chip by the CMOS process. Furthermore, a stable bias can be given to the first P channel MOSFET against the fluctuations, etc. of apower-supplyvoltage.

In the above-mentioned invention, the semiconductor integrated circuit has anAGC circuit which controls the amplification degree of the second P channel MOSFET.

Constituting the semiconductor integrated circuit in this way makes it possible to implement the AGC control of the amplification degree of the second P channel MOSFET, for example, according to the level of a signal received.

In the above-mentioned invention, the bias circuit has a third MOSFET which constitutes the first P channel MOSFET and a current mirror circuit.

Constituting the bias circuit in this way makes it possible to set the current which flows through the first P channel MOSFET and the current which flows through the third MOSFET in a specific proportional relation. Thus, the bias of the first P channel MOSFET can be stabilized against the fluctuations, etc. of a power-supply voltage.

In the above-mentioned invention, the bias circuit has the third MOSFET which together with the first P channel MOSFET constitutes the current mirror circuit, and makes the ratio of the channel width of the third MOSFET to the channel width of the first P channel MOSFET 1 : k (k≧1).

Constituting the bias circuit in this way, for example, when the channel length is made the same, can make a current as much as k times of the current flowing through the third MOSFET flow through the first P channel MOSFET, and can stabilize the bias of the first P channel MOSFET.

In the above-mentioned invention, the bias circuit is constituted in such a way that the source is connected to a power-supply voltage, the drain is connected to a constant-current power supply, and the gate is connected to the constant-current power supply.

Constituting the bias circuit in this way can keep the current flowing through the third MOSFET constant, so the current flowing through the first P channel MOSFET can be kept constant. Thus, the operating point of the first P channel MOSFET can be stabilized against the fluctuations, etc. of a power-supply voltage.

### Brief description of the Drawings

Fig. 1 shows the configuration of an RF amplifier circuit in a first embodiment.
Fig. 2 is a block diagram showing an AM-receiver IC in a first embodiment.
Fig. 3 is an explanatory drawing of flicker noise.
Fig. 4 shows the configuration of an RF amplifier circuit in a second embodiment.
Fig. 5 shows the configuration of a conventional AM-broadcast receiving circuit.

### Best Mode for Carrying Out the Invention

Described below are the embodiments of the present invention with reference to the drawings.

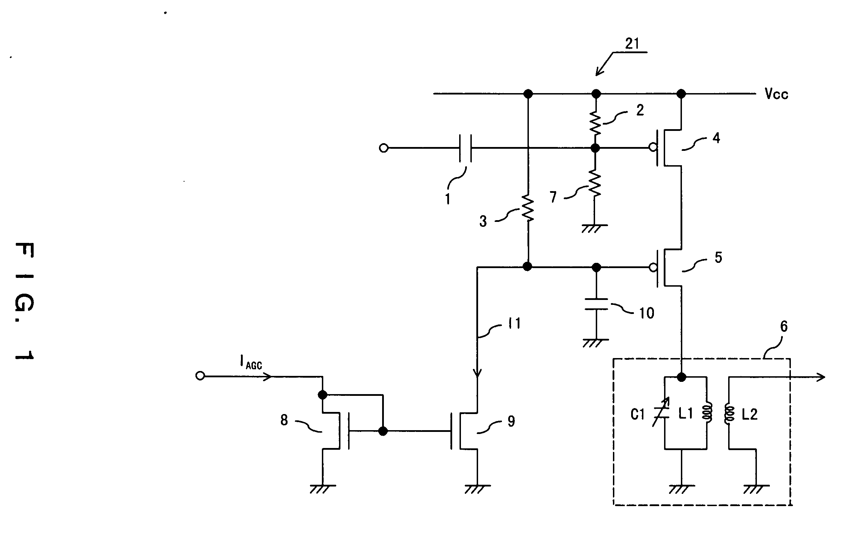

Fig. 1 shows the configuration of an RF amplifier circuit 21 which amplifies AM broadcast signals in a first embodiment.

AM broadcast signals which are received by an antenna which is not shown in Fig. 1 are inputted to one end of a capacitor 1, as shown in Fig. 1. The other end of the capacitor 1 is connected to the gate of the P channel MOSFET (first P channel MOSFET) 4. The capacitor 1 is used to cut the DC component of AM broadcast signals.

The voltage in which a power-supply voltage is divided by a resistor 2 and a resistor 7 is supplied to the gate of a P channel MOSFET 4 as a bias voltage. The resistor 2 and the resistor 7 are connected in series, the other end of the resistor 2 is connected to the power supplyVcc, and the other end of the resistor 7 is grounded.

A P channel MOSFET (second P channel MOSFET) 5 is cascade-connected to the P channel MOSFET 4. A resistor 3 connected to the power supply Vcc and the drain of a N channel MOSFET 9 which will be explained later are connected to the gate of the P channel MOSFET 5. Also, a bypass capacitor 10 is connected to the gate of the P channel MOSFET 5, and the other end of the capacitor 10 is grounded.

The cascade-connection of the P channel MOSFET 4 and the P channel MOSFET 5 realizes a reduction of the feedback capacitance between the gate and source of the P channel MOSFET 4, thereby improving the high-frequency characteristics of the P channel MOSFET 4.

A tuning circuit 6 is connected to the drain of the P channel MOSFET 5. The tuning circuit 6 comprises a tuning capacitor C1 and tuning coils L1 and L2, and selects and outputs the frequency of AM broadcast signals which are controlled by the AGC circuit and are outputted from the P channel MOSFET 5. The other ends of the tuning capacitor C1 and the tuning coils L1 and L2 are grounded.

The P channel MOSFET 4 and the P channel MOSFET 5 constitute the RF amplifier circuit 21 for amplifying the AM broadcast signals.

An AGC current I AGC which controls the gain of the RF amplifier circuit 21 is inputted to the drain of the N channel MOSFET 8 from the AGC (auto gain control) circuit which is not shown in Fig. 1. The drain and gate of the N channel MOSFET 8 are connected, and the source is grounded.

The gate of a N channel MOSFET 9 is connected to the gate of the N channel MOSFET 8. The drain of the N channel MOSFET 9 is connected to the gate of the P channel MOSFET 5, and the source is grounded.

The N channel MOSFET 8 and the N channel MOSFET 9 constitute the current mirror circuit, and a current proportional to the AGC current I AGC which flows into the drain of the N channel MOSFET 8 flows through the N channel MOSFET 9.

Thus, the bias voltage of the P channel MOSFET 5 changes according to the AGC current I AGC which is outputted from the AGC circuit, the amplification degree of the P channel MOSFET 5 is controlled thereby, and the level of the RF signal to be outputted changes thereby.

The gate of the P channel MOSFET 5 does not necessarily need to be controlled by the AGC, but may be, for example, a fixed bias.

The RF amplifier circuit 21 is integrated into one chip together with a circuit which implements a signal processing at a later step necessary to receive AM broadcasting including mixing, frequency conversion, etc. a latch circuit which will be described later, and a digital circuit such as a shift register, and the output signal of the tuning circuit 6 is outputted to a mixer circuit which will be described later, etc.

Next, described below is the operation of the RF amplifier circuit 21 which is constituted as described above.

The DC component of the AM broadcast signals inputted from an antenna which is not shown in Fig. 1 is cut by the capacitor 1, and the AC component is amplified by the P channel MOSFET 4. Then, the RF signal outputted from the P channel MOSFET 4 is amplified to a specific level by the P channel MOSFET 5 which is controlled by the AGC circuit and is outputted to the tuning circuit 6.

In other words, a current I1 corresponding to the source current I AGC of the N channel MOSFET 8 flows to the source of the N channel MOSFET 9. The larger the value of the current I AGC is, the larger the value of the corresponding current I1 becomes, and the bias voltage of the P channel MOSFET 5 changes. Thus, a voltage VDS between the drain and source of the P channel MOSFET 4 changes, and the VDS is lowered and the gain is controlled.

According to the amplifier circuit for AM broadcasting in the first embodiment, the cascade-connection of the P channel MOSFET 4 and the P channel MOSFET 5 realizes a reduction of the feedback capacitance Cgd between the source and gate of the P channel MOSFET 4. Thus, the high-frequency characteristics of the P channel MOSFET 4 can be improved, and the stability of the amplifier circuit 21 can be increased.

Furthermore, connecting the output of the AGC circuit to the gate of the P channel MOSFET 5 makes it possible to control the amplification degree of the P channel MOSFET 5 by an AGC signal, and makes the level of an RF signal constant.

The tuning circuit 6 amplifies the constant-level RF signal outputted from the second P channel MOSFET 5, and outputs the amplified RF signal to a mixer in the following step which is not shown in Fig. 1. In the subsequent signal processing circuit (not shown in Fig. 1) including the mixer and the frequency conversion unit, the remaining processing necessary to receive AM broadcasting is implemented, and a station for the input signal is selected, then the signal is amplified, demodulated, etc. at an output step, and is outputted as an audio signal.

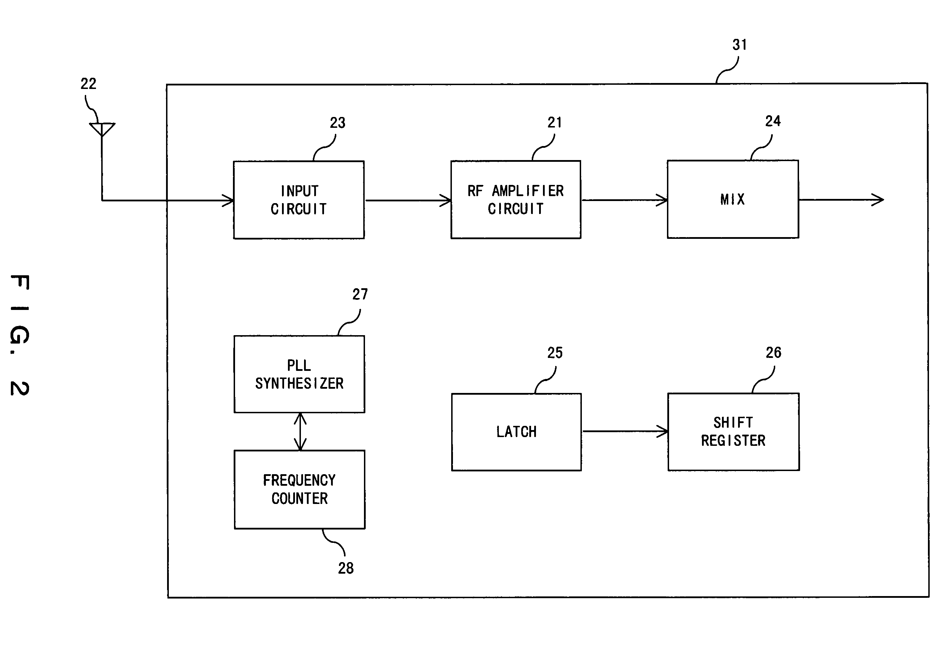

Fig. 2 is a block diagram showing the AM-receiver IC (semiconductor integrated circuit) 31 in which both the amplifier circuit for AM broadcasting 21 comprising the P channel MOSFET and the CMOS digital circuit are integrated into one chip.

This AM-receiver IC 31 forms an input circuit 23 which selects a frequency for the signal inputted from an antenna 12, the RF amplifier circuit 21 which amplifies AM broadcast signals, FM and AM receiving circuits comprising a MIX circuit 24 which converts the AM broadcast signals amplified by the RF amplifier circuit 21 into a medium frequency, a CMOS digital circuit comprising a latch circuit 25, a shift register 26, a PLL synthesizer 27, a frequency counter 28, etc. on one chip by means of a CMOS process.

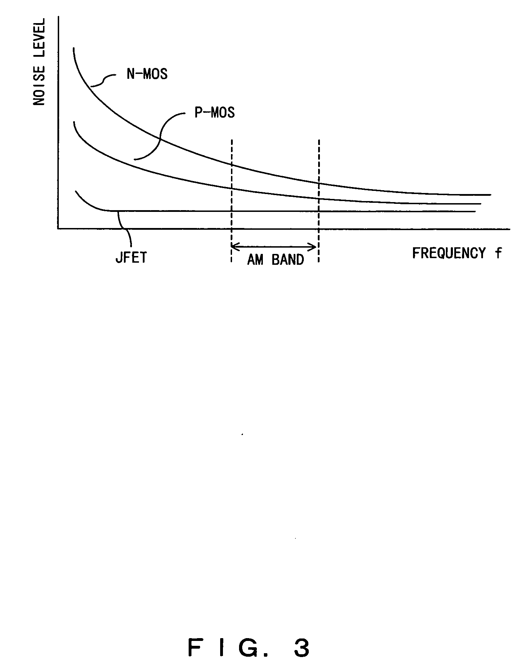

Fig. 3 shows the flicker noise characteristics of the JFET, P channel MOSFET, and N channel MOSFET.

Flicker noise which is the internal noise of a MOS semiconductor becomes large in its noise level in inverse proportion to its frequency, as shown in Fig. 3. Consequently, if the RF amplifier is constituted by a MOS circuit when the signal to be handled is a low-frequency signal such as AM broadcast signals, the noise level is higher compared with when the JFET is used.

However, when the N channel MOSFET and the P channel MOSFET are compared, the P channel MOSFET is small in its noise level even in a low-frequency region than the N channel MOSFET. In the embodiment of the present invention, the level of flicker noise is kept at a comparatively low level by constituting the RF amplifier circuit 21 for amplifying AM broadcast signals by the P channel MOSFET.

In addition, since the P channel MOSFET can be made in the process of manufacturing CMOSs, it is possible to integrate into one chip the CMOS circuit such as a receiving circuit of AM broadcast signals including the RF amplifier circuit 21, the latch circuit 25, the shift register 26, etc., and it is possible to miniaturize the circuit of the receiver. Also, since the whole of the circuits of radio equipment can be made by the same CMOSprocess, the manufacturing process canbe simplified and the manufacturing cost can be reduced.

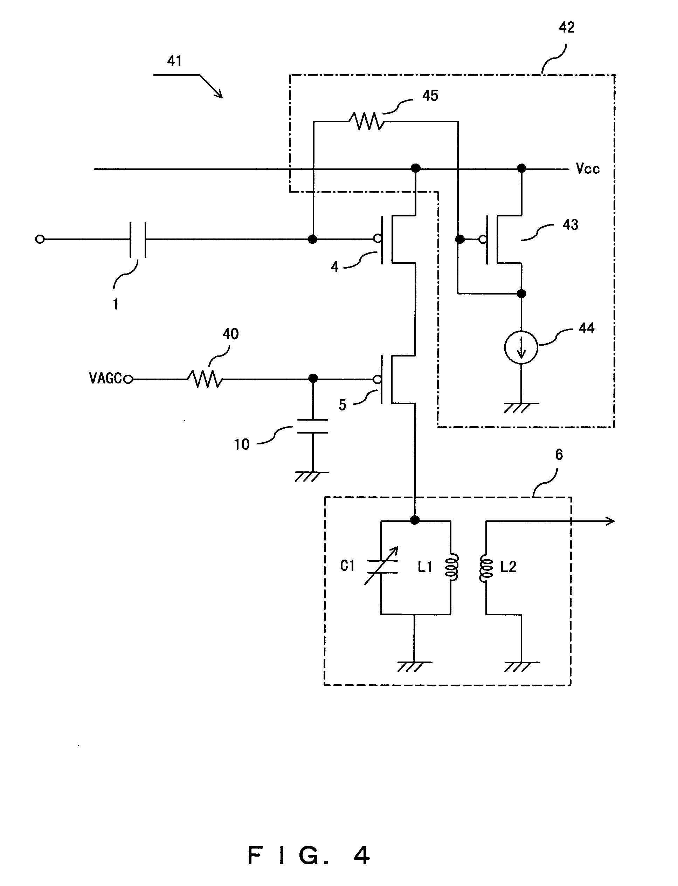

Fig. 4 shows the configuration of an RF amplifier circuit 31 in a second embodiment of the present invention. In the explanation of Fig. 4, the same number or mark is given to the same constituent as in Fig. 1 to omit a detailed explanation of the constituent.

What is different between the circuit shown in Fig. 4 and that shown in Fig. 1 is that the AGC control voltage VAGC outputted from the AGC circuit which is not shown in Fig. 4 is inputted to the gate of the P channel MOSFET 5 and that a bias circuit 42 constituting the current mirror circuit together with the P channel MOSFET 4 is provided.

In Fig. 4, the AGC control voltage VAGC is inputted to the gate of the P channel MOSFET 5 via the resistor 40; the voltage VDS between the drain and source of the P channel MOSFET 4 changes according to this AGC control voltage VAGC; and the gain is controlled by lowering the VDS. For your information, VDS = Vcc - (VAGC + VGS5), and VGS5 is the voltage between the gate and source of the P channel MOSFET 5.

The bias circuit 42 comprises the P channel MOSFET 43 including a constant-current power supply 44.

The source of the P channel MOSFET 43 is directly connected to the power supply Vcc, the drain is connected to the constant-current power supply 44, and the gate is connected to the drain. Also, the gate of the P channel MOSFET 4 is connected to the gate of P channel MOSFET 4 via the resistor 45.

The resistor 45 connected in series to the gate of the P channel MOSFET 43 is used for AM broadcast signals not to go around the P channel MOSFET 43 and to raise the input impedance of the P channel MOSFET 4.

Since the P channel MOSFET 4 and the P channel MOSFET 43 constitute the current mirror circuit, when the channel area of both P channel MOSFET 4 and P channel MOSFET 43 is equal, the current flowing through both P channel MOSFET 4 and P channel MOSFET 43 becomes equal.

Then, when the channel length of the P channel MOSFET 4 is L1, the channel width is W1, the channel length of the P channel MOSFET 43 is L2, and the channel width is W2, the respective channel lengths and channel widths are set so that the relations of L1 = L2, and W1 = k • W2 (k≧1; k is a fixed number larger than 1 in the embodiment) are establsished. The fixed number k is set so that the gain of the first P channel MOSFET 4 which is cascade-connected becomes optimum.

The RF amplifier circuit 41 in a second embodiment can reduce the feedback capacitance of the P channel MOSFET 4 and enhance the stability of the RF amplifier circuit 41 by cascade-connectig the P channel MOSFET 4 and P channel MOSFET 5, both of which amplify the AM broadcast signals, in the same way as in the first embodiment.

Also, constituting the current mirror circuit by the P channel MOSFET 4 and the P channel MOSFET 43 of the bias circuit 42 makes it possible to supply a stable bias to the P channel MOSFET 4. Thus, the bias of the P channel MOSFET 4 can be stablized against the fluctuations, etc. of a power-supply voltage.

Furthermore, setting the channel width of the P channel MOSFET 43 of the bias circuit 42 to 1/k of the channel width of the P channel MOSFET 4, when a current of 1/k is made to flow to the p channel MOSFET 43, can make a current as much as k times flow to the P channel MOSFET 4. Also, connecting the constant-current power supply 44 to the drain of the P channel MOSFET 43 can keep the current flowing to the P channel MOSFET 43 constant. Thus, the operating point of the P channel MOSFET 4 can be stabilized against the fluctuations of the power-supply voltage and the changes of temperature, etc.

The present inventionmaybe constituted as follows without being limited to the embodiment described above.
(1) The amplifier circuit of AM broadcast signals related to the present invention may be mounted not only on an IC for an AM receiver, but also on an IC for communications which is used for a cellular phone and a radio LAN which have a radio line corresponding to a higher frequency.
(2) The bias circuit 42 may be not only a current mirror circuit comprising the p channel MOSFET or the N channel MOSFET and the current power-supply 44, but also any circuit if it can stablize the bias.

According to the present invention, it is possible to suppress the flicker noise in the frequency bandwidth of AM broadcasting and integrate the amplifier circuit of AM broadcast signals and the CMOS digital circuit into one chip. Furthermore, it is possible to stabilize the bias against the fluctuations, etc. of a power-supply voltage by providing a bias circuit.

## Claims

1. A semiconductor integrated circuit, comprising
an amplifier circuit of AM broadcast signals having a first P channel MOSFET for amplifying AM broadcast signals and a second P channel MOSFET cascade-connected to the first P channel MOSFET; and
a CMOS digital circuit.

2. A semiconductor integrated circuit, comprising:
an amplifier circuit of AM broadcast signals having
a first P channel MOSFET for amplifying AM broadcast signals and a second P channel MOSFET cascade-connected to the first P channel MOSFET; and
a CMOS digital circuit; wherein
the first P channel MOSFET, the second P channel MOSFET and the CMOS digital circuit are formed on the same circuit board by a CMOS process.

3. A semiconductor integrated circuit, comprising:
an amplifier circuit of AM broadcast signals having a first P channel MOSFET for amplifying AM broadcast signals and a bias circuit for giving a specific bias to the first P channel MOSFET; and
a CMOS digital circuit; wherein
the first P channel MOSFET, the bias circuit and the CMOS digital circuit are formed on the same circuit board by the CMOS process.

4. A semiconductor integrated circuit, comprising:
an amplifier circuit of AM broadcast signals having a first P channel MOSFET for amplifying AM broadcast signals, a second P channel MOSFET cascade-connected to the first P channel MOSFET and a bias circuit for giving a specific bias to the first P channel MOSFET; and
a CMOS digital circuit, wherein
the first P channel MOSFET, the second P channel MOSFET, the bias circuit and the CMOS digital circuit are formed on the same circuit board by the CMOS process.

5. The semiconductor integrated circuit according to claim 1, 2, or 4, which has an AGC circuit for controlling the amplification degree of the second P channel MOSFET.

6. The semiconductor integrated circuit according to claim 2, 3, 4, or 5, wherein
the bias circuit has the thirdMOSFET which together with the first P channel MOSFET constitutes a current mirror circuit.

7. The semiconductor integrated circuit according to claim 6, wherein
the bias circuit has the thirdMOSFET which together with the first P channel MOSFET constitutes a current mirror circuit, and makes the ratio of the channel width of the third MOSFET to the channel width of the first P channel MOSFET 1 : k (k≧1).

8. The semiconductor integrated circuit according to claim 6 or 7, wherein
the bias circuit is constituted in such a way that one end of either the drain or the source is connected to a power-supply voltage, the other end of either the drain or the source is connected to the constant-current power supply, and the gate is connected to the constant-current power supply.

9. A method of manufacturing a semiconductor integrated circuit which forms a first P channel MOSFET for amplifyingAMbroadcast signals and a second P channel MOSFET cascade-connected to the first P channel MOSFET, and a CMOS digital circuit on the same circuit board by the CMOS process.

10. The method of manufacturing a semiconductor integrated circuit, wherein
an AGC circuit for controlling the amplification degree of the second P channel MOSFET is provided.

11. The method of manufacturing a semiconductor integrated circuit according to claim 9, which forms the third MOSFET and the second P channel MOSFET constituting a current mirror circuit , and which makes the ratio of the channel width of the third MOSFET to the channel width of the first P channel MOSFET 1 : k (k≧1).
